# FASCICULE DE BREVET EUROPEEN

(11) **EP 3 692 352 B1**
(45) Date de publication et mention de la délivrance du brevet: **14.12.2022**
(21) Numéro de dépôt: 18779810.3
(22) Date de dépôt: 18.09.2018
(51) Int. Cl.: G01M 3/40, G01R 27/08, G01N 27/00

(54) **DISPOSITIF DE SURVEILLANCE POUR LA DÉTECTION, EN CONTINU, DE DÉFAUTS DANS UNE SECTION DE CANALISATION ET UN SYSTÈME DE SURVEILLANCE ÉQUIPÉ D'AU MOINS DEUX DISPOSITIFS DE SURVEILLANCE**
VORRICHTUNG ZUR KONTINUIERLICHEN ÜBERWACHUNG VON DEFEKTEN IN EINEM ROHRLEITUNGSABSCHNITT SOWIE EIN ÜBERWACHUNGSSYSTEM MIT MINDESTENS ZWEI ÜBERWACHUNGSVORRICHTUNGEN
CONTINUOUS MONITORING DEVICE FOR DETECTING DEFECTS IN A SECTION OF PIPING AND A MONITORING SYSTEM FITTED WITH AT LEAST TWO MONITORING DEVICES

(30) Priorité: 05.10.2017 FR 1771055
(43) Date de publication de la demande: 12.08.2020
(73) Titulaire: SPADE, 92200 Neuilly-Sur-Seine (FR)
(72) Inventeur: HUSS, Gérard, 28230 Epernon (FR)
(74) Mandataire: RVDB
(86) Numéro de dépôt international: PCT/IB2018/057136
(87) Numéro de publication internationale: WO 2019/069161

(56) Documents cités:
- EP-A1- 0 560 443
- JP-A- 2014 084 490
- JP-A- 2014 084 490
- US-A- 5 828 219
- US-A1- 2010 213 955
- US-A1- 2010 213 955

## Description

La présente invention concerne un dispositif de surveillance pour la détection, en continu, de défauts dans une section de canalisation et un système de surveillance équipé d'au moins deux dispositifs de surveillance.

### DOMAINE TECHNIQUE

L'invention se situe dans le domaine technique de la surveillance de canalisations comportant une structure métallique, notamment enterrées, afin de détecter un défaut de la canalisation nécessitant des travaux de réparation ou de remplacement.

L'invention sera notamment particulièrement adaptée à la surveillance de pipelines assurant le transport de fluides gazeux ou liquides, tels que par exemple des hydrocarbures, sur des terrains naturels ou artificiels.

### ART ANTERIEUR

On connait à ce jour différents moyens de vérification de l'état d'une canalisation.

Selon un premier mode de contrôle, on réalise le contrôle par l'extérieur de la canalisation, notamment à l'aide de magnétomètres, à cet effet des opérateurs suivent la canalisation recherchant des anomalies magnétiques correspondant à des défauts de la canalisation. Cette technique a notamment comme avantage de pouvoir être effectuée sans cesser le fonctionnement de la canalisation.

Toutefois cette vérification est lourde à mettre en œuvre et ne peut être réalisée que ponctuellement, elle nécessite par ailleurs un temps considérable notamment en fonction de la longueur de la canalisation. Ce mode de contrôle n'est cependant pas adapté à des canalisations profondément enterrées ou encore situées dans des milieux difficiles d'accès.

Selon un second mode de contrôle, on réalise le contrôle de la canalisation par l'intérieur, notamment à l'aide de robots se déplaçant dans la conduite. Cette technique est intéressante dans le sens où elle nécessite peu de main d'œuvre et permet de surveiller des longueurs importantes de canalisation.

Toutefois cette technique n'est pas adaptée à la surveillance de canalisation présentant des variations de diamètre trop importante ou encore de faible diamètre ou encore présentant des sections fortement coudées. Par ailleurs, le contrôle par l'intérieur nécessite l'arrêt du fonctionnement de la canalisation et ne peut par conséquent pas être effectué en continu. Les documents US2010/0213955 et JP2014-84490 divulguent des dispositifs de surveillance pour la détection de défauts dans une section de canalisation.

### OBJET DE L'INVENTION

Un premier but de la présente invention est de résoudre tout ou partie des problèmes techniques liés à l'art antérieur précité.

Un autre but de la présente invention est de proposer un dispositif de surveillance permettant la surveillance en continu d'une section de canalisation sans arrêt de fonctionnement de la canalisation.

Un autre but de la présente invention est de proposer un dispositif de surveillance permettant de générer une alarme en cas de détection d'un endommagement de la canalisation,

Un autre but de la présente invention est de proposer un dispositif de surveillance automatique ne nécessitant pas d'intervention humaine dans la phase de détection des anomalies.

Un autre but de la présente invention est de proposer un dispositif de surveillance permettant de distinguer entre une usure régulière de la canalisation et un autre type d'endommagement.

Un autre but de la présente invention est de proposer un dispositif de surveillance permettant de réaliser un historique de l'état de chaque section d'une canalisation.

Un autre but de la présente invention est de proposer un dispositif de surveillance pouvant être facilement adapté à des canalisations équipées d'un dispositif de protection cathodique.

### RESUME DE L'INVENTION

La présente invention concerne un dispositif de surveillance pour la détection, en continu, de défauts dans une section de canalisation, selon la revendication 1.

L'invention vise également à protéger un système de surveillance comportant au moins deux dispositifs de surveillance tels que précités.

### DEFINITIONS

Le terme « en continu » dans l'expression surveillance en continu signifie, au sens de la présente invention, que la surveillance de la section de canalisation peut être réalisée sans interruption.

Par le mot « canalisation », on entend dans la présente demande tout type de canalisation comportant une couche conductrice métallique et notamment une canalisation de type pipeline pour le transport de tout fluide gazeux ou liquide.

### BREVE DESCRIPTION DES FIGURES

La présente invention sera mieux comprise à la lecture d'un exemple détaillé de réalisation en référence aux figures annexées, fournies à titre d'exemple non limitatif, parmi lesquels :
- la figure 1 représente un exemple de réalisation schématique d'un dispositif conforme à l'invention,
- la figure 2 représente en vue schématique et en perspective un système de surveillance disposé sur deux sections de canalisation à surveiller.

### DESCRIPTION DETAILLEE DE L'INVENTION

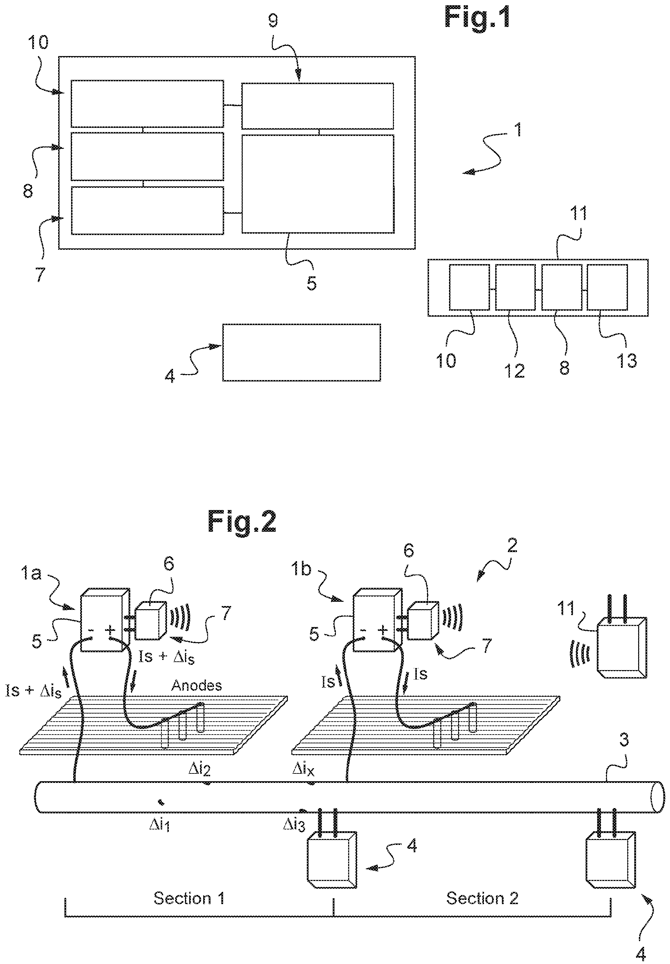

En se reportant à la figure 1, on voit représenté un dispositif de surveillance 1 pour la détection, en continu, de défauts dans une section de canalisation.

En se reportant à la figure 2, on voit représenté un système de surveillance 2 comportant deux dispositifs de surveillance 1a et 1b, permettant de surveiller respectivement les sections S1 et S2 d'une canalisation 3.

A la figure 1, on voit que le dispositif de surveillance 1 comprend des moyens d'injection 4 aptes à générer un courant électrique au niveau d'une première extrémité de section de canalisation 3.

Le dispositif 1 comprend également au moins un poste de soutirage 5 au niveau de la seconde extrémité de section de la canalisation. Le poste de soutirage 5 permet l'évacuation du courant injecté via une mise à la masse. Cette mise à la masse est réalisée en connectant, de manière connue le poste de soutirage 5 à la terre comme représentée à la figure 2.

Le dispositif de contrôle 1 comprend en outre un boîtier de contrôle 6 associé au poste de soutirage 5. Ce boîtier de contrôle 6 peut être soit câblé sur le poste de soutirage 5 en amont ou en aval de ce dernier, comme représenté à la figure 2, soit disposé dans le poste de soutirage 5 selon une variante avantageuse. Dans les différentes options, les moyens de mesure 7 comportent un shunt de mesure placé sur ou dans le poste de soutirage 5.

Le boitier de contrôle 6 comprend des moyens de mesure 7 d'au moins une composante du courant reçu par le poste de soutirage 5. Avantageusement, la composante mesurée sera, en cas d'injection d'une tension continue, l'intensité du courant au moyen d'un ampèremètre ou équivalent.

Cependant d'autres mesures servant à réaliser l'analyse peuvent également être effectuées et notamment en cas de tension variable, des mesures de tension et d'intensité permettant d'analyser les variations de rapports tension/intensité du signal.

Le boîtier de contrôle 6 comporte en outre des moyens d'analyse 8 permettant de détecter, à partir des mesures obtenues par les moyens de mesure 7, une variation de la composante reçue correspondant à un type de défaut de la canalisation.

Le boitier de contrôle 6 comprend en outre des moyens d'alimentation 9, ces moyens d'alimentation 9, classiquement réalisés avec une batterie ou un câblage sur secteur, pouvant être partagés ou non avec ceux du poste de soutirage 5.

Le boitier de contrôle 6 comprend en outre des moyens de transmission 10 vers une unité centrale 11. Ces moyens de transmission 10, radiofréquences, permettent la transmission des données vers l'unité centrale 11 avantageusement positionnée au niveau du poste de commande du réseau de canalisation. Ces données transmises peuvent consister en la transmission des mesures effectuées par les moyens de mesure 7 et/ou de l'analyse effectuée par les moyens d'analyse 8.

Il est important de souligner en effet que lesdits moyens d'analyse 8 sont partagés entre le boiter 6 et l'unité centrale 11.

Il est également important de souligner que certaines canalisations sont déjà équipées de moyens d'alimentation 4 et d'au moins un poste de soutirage 5. Ces éléments 4 et 5 sont en effet utilisés pour réaliser la protection cathodique de la canalisation afin de protéger la couche métallique des canalisations des phénomènes de corrosion.

Dans cette hypothèse, le présent dispositif de surveillance 1 pourra de manière avantageuse reprendre ses éléments 4 et 5 et les connecter au boitier de contrôle 6 pour permettre la réalisation de l'invention.

Dans le cas de nouvelle installation devant être équipée de moyens de protection cathodique, il sera avantageux de proposer un dispositif global intégrant les fonctions de protection cathodique et de surveillance de la présente invention.

L'unité centrale 11 permet de réceptionner les données transmises par le ou les boîtiers 6 auxquels elle est reliée. L'unité centrale 11 comprend des moyens d'alarme 12 permettant d'alerter en cas de mise au jour d'un défaut de la section de canalisation surveillée. Les moyens d'alarmes 12, notamment visuels ou sonores, permettent d'indiquer avantageusement la section présentant un défaut et le type de défaut.

Le fonctionnement du dispositif de contrôle 1 est continu et ne nécessite pas de main d'œuvre ou encore d'arrêt du fonctionnement de la canalisation 3. Le dispositif de surveillance 1 injecte le courant en continu, à l'aide des moyens d'injection 4, et les moyens de mesure 7 mesurent les variations du courant collecté par le poste de soutirage 5.

En se reportant à la figure 2 on voit une section S1 présentant des défauts et une section S2 sans défaut. La création d'un défaut entraîne un accroissement du courant détecté par les moyens de mesure 7 et provenant du courant transmis par les moyens d'injection 4 et avantageusement correspondant au courant transmis pour la protection cathodique. Cet accroissement dépend du type de défaut et correspond à un pic dont la phase analysable avec le plus de précision dure environ une dizaine de minutes.

En effet, il est important de noter que la protection cathodique est un procédé électrochimique qui permet d'empêcher la corrosion de l'acier dans le sol. Les pipelines sont des tubes en acier avec un revêtement protecteur et isolant électrique mais comportant des défauts suite à des décollements, des arrachements ou des frottements dans le sol. En temps normal, il y a un équilibre électrochimique entre l'acier et le sol entretenu par un courant cathodique. Lorsque ce revêtement est endommagé, la protection cathodique prend le relais de la protection par revêtement de l'acier.

L'apparition d'un défaut entraîne une augmentation de courant pendant un temps très court, de l'ordre de quelques centièmes de seconde puis ce courant décroît avec la polarisation électrochimique de l'acier. Le courant initial dépendra de l'aire du défaut et de la conductivité électrique du sol environnant (résistance électrique du défaut dans le sol).

Le temps de décroissance du courant ou de polarisation peut être de quelques minutes à plusieurs heures ou même plusieurs jours selon la densité de courant de polarisation (rapport du courant sur l'aire du défaut exprimé en mA/m²), il peut dépendre aussi de la composition chimique du sol.

L'analyse de la variation de courant dans les quelques secondes qui suivront le pic de courant initial permet d'évaluer le degré de dégradation du revêtement et par conséquent le risque d'atteinte de l'acier.

Pour détecter de manière certaine cette phase, on prévoit avantageusement une fréquence d'échantillonnage des moyens de mesure 7 comprise 0.01 et 1Hz.

En fonction du type de défaut, la variation de la composante du courant est différente, et notamment en ce qui concerne son amplitude ou la forme de son pic. En d'autres termes il est possible à partir d'une base de données reprenant les différents schémas de variations du courant en fonction du type de défaut de parvenir à déterminer le type de défaut à partir des seules mesures de variation du courant.

A cet effet, les moyens d'analyse 8 comportent des moyens de comparaison entre la variation d'intensité mesurée par unité de temps dans les mesures de la composante intensité avec une base de données 13 permettant de lier la ou les variations à un type de défaut.

Dans une version basique, les moyens de comparaison comportent un seuil bas permettant la seule prise en compte des variations d'intensité par unité de temps supérieures au seuil bas de manière à éviter les fausses alarmes. Ce seuil permet notamment d'éviter les fausses alarmes dues à une augmentation très faible et régulière due à l'usure normale de la couche métallique de la canalisation.

Dans une version avantageuse, les moyens de comparaison permettent de distinguer entre les principales sources d'endommagement présentant des schémas de variation différents à savoir notamment un endommagement de type choc mécanique sur la surface de la canalisation, de type mise en contact entre la gaine et le tube franc de la canalisation, de type dégradation liée à la foudre, de type raccord isolant défectueux ou encore de type dégradation liée à une mesure de potentiel sur témoin métallique.

En ce qui concerne l'endommagement suite à une mesure de potentiel, qui est la technique actuellement utilisée pour le contrôle de la protection cathodique, il est prévu de manière avantageuse, au niveau du dispositif de contrôle 1 des moyens de débrayage. Ces moyens de débrayage permettent la réalisation de contrôles externes sans déclenchement d'alarme liée auxdits contrôles externes.

Pour ce faire l'opérateur en charge du contrôle externe d'une section de canalisation réalise, avant contrôle externe, le débrayage du dispositif de surveillance 1 et réenclenche ce dernier une fois le contrôle externe terminée.

Les moyens de débrayage pourront notamment consister à désactiver les moyens d'alarmes 12 uniquement pour la section de canalisation considérée.

D'une manière avantageuse, les moyens d'analyse 8 comportent des moyens d'enregistrement permettant de créer un historique des défauts d'une section de canalisation, permettant de suivre l'évolution de la section de la canalisation. Cette caractéristique est notamment intéressante puisqu'elle permet d'anticiper les travaux de maintenance de la canalisation. Ces moyens d'enregistrement sont, de manière avantageuse, confondus avec la base de données 13.
Le dispositif de surveillance tel que décrit dans la présente demande permet la surveillance en continu d'une section de canalisation sans arrêt de fonctionnement de la canalisation, sans intervention humaine dans la phase de détection des défauts. Il peut en outre être facilement adapté à des canalisations déjà équipées d'un dispositif de protection cathodique.

Bien entendu, d'autres caractéristiques de l'invention auraient également pu être envisagées sans pour autant sortir du cadre de l'invention définie par les revendications ci-après.

A titre d'exemple, le système de surveillance comporte une multitude de dispositifs de surveillance permettant de couvrir tout ou partie de la canalisation à surveiller ainsi que les différentes parties de raccordement prévus au niveau de la canalisation ou entre plusieurs canalisations.

## Revendications

1. Dispositif de surveillance pour la détection, en continu, de défauts dans une section de canalisation sous protection cathodique mise en œuvre par :
- des moyens d'injection (4) aptes à générer un courant électrique cathodique au niveau d'une première extrémité de la section de la canalisation,
- un poste de soutirage (5) au niveau d'une seconde extrémité de la section de la canalisation, permettant l'évacuation du courant électrique cathodique via une mise à la masse,
**caractérisé en ce que** le dispositif comprend un boîtier de contrôle (6) avec des moyens de mesure (7) d'au moins une composante du courant électrique cathodique reçu par le poste de soutirage et des moyens d'analyse (8) pour détecter, à partir des mesures obtenues par les moyens de mesure (7), une variation de la composante du courant électrique cathodique reçu correspondant à un type de défaut de la canalisation.

2. Dispositif de surveillance selon la revendication 1 dans lequel le boitier de contrôle (6) comporte des moyens de transmission (10) radiofréquences vers une unité centrale (11) des mesures effectuées par les moyens de mesure et/ou de l'analyse effectuée par les moyens d'analyse, lesdits moyens d'analyse (8) étant distribués entre le boiter (6) et l'unité centrale (11).

3. Dispositif de surveillance selon la revendication 2 dans lequel l'unité centrale comprend des moyens d'alarme (12) permettant d'alerter en cas de détection d'un défaut de la section de canalisation surveillée.

4. Dispositif de surveillance selon l'une quelconque des revendications précédentes dans lequel les moyens de mesure (7) comportent un shunt de mesure placé sur ou dans le poste de soutirage (5).

5. Dispositif de surveillance selon l'une quelconque des revendications précédentes dans lequel la fréquence d'échantillonnage des moyens de mesure est comprise 0.01 et 1Hz.

6. Dispositif de surveillance selon l'une quelconque des revendications précédentes dans lequel les moyens d'analyse (8) comportent des moyens de comparaison entre la variation d'intensité mesurée par unité de temps dans les mesures de la composante intensité avec une base de données permettant de lier la ou les variations à un type de défaut.

7. Dispositif de surveillance selon la revendication 6 dans lequel les moyens de comparaison comportent un seuil bas permettant la seule prise en compte des variations d'intensité par unité de temps supérieures au seuil bas de manière à éviter les fausses alarmes.

8. Dispositif de surveillance selon l'une quelconque des revendications précédentes comportant des moyens de débrayage permettant la réalisation de contrôles externes sans déclenchement d'alarme liée auxdits contrôles externes.

9. Dispositif de surveillance selon l'une quelconque des revendications précédentes dans lequel le boitier de contrôle (6) est intégré au poste de soutirage (5).

10. Dispositif de surveillance selon l'une quelconque des revendications précédentes dans lequel les moyens d'analyse (8) comportent des moyens d'enregistrement et une base de données (13) permettant de créer un historique des défauts d'une section de canalisation.

11. Système de surveillance comportant au moins deux dispositifs de surveillance (1) selon l'une quelconque des revendications précédentes et une unité centrale (11) permettant la surveillance de plusieurs sections de canalisation.

## Patentansprüche

1. Vorrichtung zur kontinuierlichen Überwachung zum Erkennen von Defekten in einem Rohrleitungsabschnitt unter Kathodenschutz, umgesetzt durch:
- Injektionsmittel (4), die imstande sind, einen kathodischen elektrischen Strom im Bereich eines ersten Endes des Rohrleitungsabschnitts zu erzeugen,
- eine Abnahmestation (5) im Bereich eines zweiten Endes des Rohrleitungsabschnitts, die das Abführen des kathodischen elektrischen Stroms über einen Masseanschluss ermöglicht,
**dadurch gekennzeichnet, dass** die Vorrichtung ein Steuergerät (6) mit Messmitteln (7) mindestens einer Komponente des kathodischen elektrische Stroms umfasst, der von der Abnahmestation empfangen wird, und Analysemitteln (8) zum Erkennen aus den von den Messmitteln (7) erhaltenen Messwerten einer Variation der Komponente des empfangenen kathodischen elektrischen Stroms entsprechend einer Art eines Defekts der Rohrleitung.

2. Überwachungsvorrichtung nach Anspruch 1, wobei das Steuergerät (6) Funkfrequenz-Übertragungsmittel (10) der Messungen, die von dem Messmitteln durchgeführt werden, und/oder der Analyse, die von den Analysemitteln durchgeführt wird, zu einer Zentraleinheit (11) beinhaltet, wobei die Analysemittel (8) zwischen dem Gerät (6) und der Zentraleinheit (11) verteilt sind.

3. Überwachungsvorrichtung nach Anspruch 2 wobei die Zentraleinheit Alarmmittel (12) umfasst, die es ermöglichen, im Falle des Erkennens eines Defekts des überwachten Rohrleitungsabschnitts eine Warnung abzugeben.

4. Überwachungsvorrichtung nach einem der vorstehenden Ansprüche, wobei die Messmittel (7) einen Messshunt beinhalten, der auf oder in der Abnahmestation (5) platziert ist.

5. Überwachungsvorrichtung nach einem der vorstehenden Ansprüche, wobei die Abtasthäufigkeit der Messmittel zwischen 0,01 und 1Hz liegt.

6. Überwachungsvorrichtung nach einem der vorstehenden Ansprüche, wobei die Analysemittel (8) Mittel zum Vergleichen zwischen der gemessenen Stromstärkenvariation je Zeiteinheit in den Messungen der Stromstärkenkomponente mit einer Datenbank umfasst, die es ermöglichen, die Variation oder Variationen einer Art von Defekt zuzuweisen.

7. Überwachungsvorrichtung nach Anspruch 6 wobei die Mittel zum Vergleichen eine untere Schwelle beinhalten, die nur die Berücksichtigung der Stromstärkenvariationen je Zeiteinheit, die größer als die untere Schwelle ist, ermöglichen, um falsche Alarme zu vermeiden.

8. Überwachungsvorrichtung nach einem der vorstehenden Ansprüche, die Abschaltmittel beinhaltet, die die Durchführung von externen Kontrollen ohne Auslösen eines Alarms in Verbindung mit den externen Kontrollen ermöglicht.

9. Überwachungsvorrichtung nach einem der vorstehenden Ansprüche, wobei das Steuergerät (6) in die Abnahmestation (5) integriert ist.

10. Überwachungsvorrichtung nach einem der vorstehenden Ansprüche, wobei die Analysemittel (8) Speichermittel und eine Datenbank (13) beinhalten, die es ermöglichen, eine Historie der Defekte eines Rohrleitungsabschnitts zu erstellen.

11. Überwachungssystem, das mindestens zwei Überwachungsvorrichtungen (1) nach einem der vorstehenden Ansprüche und eine Zentraleinheit (11) beinhaltet, die die Überwachung mehrerer Rohrleitungsabschnitte ermöglichen.

## Claims

1. A monitoring device for the continuous detection of defects in a piping section under cathodic protection implemented by:
- injection means (4) able to generate a cathodic electric current at a first end of the section of the piping,
- a tapping station (5) at a second end of the section of the piping, enabling the discharge of the cathodic electric current via grounding, **characterised in that** the device comprises a control box (6) with means (7) for measuring at least one component of the cathodic electric current received by the tapping station and analysis means (8) for detecting, from the measurements obtained by the measurement means (7), a variation of the component of the received cathodic electric current corresponding to a type of defect of the piping.

2. The monitoring device according to claim 1, wherein the control box (6) includes means (10) for radiofrequency transmission to a central unit (11) of the measurements performed by the measurement means and/or the analysis performed by the analysis means, said analysis means (8) being distributed between the box (6) and the central unit (11).

3. The monitoring device according to claim 2, wherein the central unit comprises alarm means (12) allowing warning in the event of detection of a defect of the monitored piping section.

4. The monitoring device according to any one of the preceding claims, wherein the measurement means (7) include a measurement shunt placed on or in the tapping station.

5. The monitoring device according to any one of the preceding claims, wherein the sampling frequency of the measurement means is comprised between 0.01 and 1 Hz.

6. The monitoring device according to any one of the preceding claims, wherein the analysis means (8) include means for comparing the intensity variation per unit of time in the measurements of the intensity component with a database allowing relating the variation(s) to a type of defect.

7. The monitoring device according to claim 6, wherein the comparison means include a low threshold allowing considering only the intensity variations per unit of time higher than the low threshold so as to avoid false alarms.

8. The monitoring device according to any one of the preceding claims, including declutching means allowing carrying out external controls without triggering an alarm related to said external controls.

9. The monitoring device according to any one of the preceding claims, wherein the control box (6) is integrated in the tapping station (5).

10. The monitoring device according to any one of the preceding claims, wherein the analysis means (8) include recording means and a database (13) allowing creating a history of the defects of a piping section.

11. A monitoring system including at least two monitoring devices (1) according to any one of the preceding claims and a central unit (11) enabling monitoring of several piping sections.
